# EUROPEAN PATENT SPECIFICATION

(11) **EP 3 133 632 B1**
(45) Date of publication and mention of the grant of the patent: **30.12.2020**
(21) Application number: 14889710.1
(22) Date of filing: 15.04.2014
(51) Int. Cl.: H01H 73/00, H02H 3/08, G01R 19/00, G01R 23/16

(54) **CIRCUIT BREAKER**
SCHUTZSCHALTER
DISJONCTEUR

(43) Date of publication of application: 22.02.2017
(73) Proprietor: Mitsubishi Electric Corporation, Chiyoda-ku Tokyo 100-8310 (JP)
(72) Inventor: OHASHI, Hiroaki, Tokyo 100-8310 (JP); ITAKURA, Takeshi, Tokyo 100-8310 (JP)
(74) Representative: Diehl & Partner
(86) International application number: PCT/JP2014/060711
(87) International publication number: WO 2015/159364

(56) References cited:
- JP-A- 2002 345 145
- JP-A- 2008 004 537
- JP-A- 2008 186 592
- US-A- 5 210 483
- US-A- 5 754 440
- US-A1- 2011 168 697

## Description

### Field

The present invention relates to a circuit breaker having a current measuring function.

### Background

Conventional circuit breakers, in order to accurately measure the current that flows along an electric path, are commonly configured to detect the current frequency. A frequency detection method that is commonly used in such a case involves detecting the voltage; calculating its period T on the basis of the zero crossing point of the voltage waveform (the point at which the voltage shifts from negative to positive); and obtaining the frequency as a reciprocal of the period T.

Further, in a configuration where the voltage is not detected, it is necessary to similarly calculate the period T on the basis of the zero crossing point of a current waveform and to obtain the frequency as the reciprocal of the period T. Here, because the current waveform is often distorted due to a load being connected to the electric path, it is necessary to use a frequency detection method that can reduce measurement errors. The following frequency detection method is known (for example, see Patent Literature 1) where, if the frequency (1/T) calculated from the period T deviates by, for example, 1% or more from the prescribed value, the positive-side threshold and negative-side threshold for obtaining the zero crossing are changed stepwise to recalculate the frequency. This operation is repeated until the calculated frequency comes to fall within the prescribed value of, for example, a deviation of 1% or less, and then the frequency is adopted as the detected frequency.

### Citation List

### Patent Literature

Patent Literature 1: Japanese Patent Application Laid-open No. 2012-145428

Patent US 5,754,440 discloses an apparatus for monitoring waveforms in AC electrical systems and particularly for performing harmonic analysis of the waveforms. The apparatus comprises input means sensing waveforms in said AC electrical systems and processing means determining values of harmonics in said waveforms sensed by said input means and phase angles between said harmonics and a reference waveform. The processing means include means for generating real and imaginary components of said harmonics of said waveforms, for determining a ratio of said harmonics with a larger of said components always as a denominator, for storing a phase angle table of ratios for angles up to 45° and for determining said phase angles from said ratio, said phase angle table and signs of said components. In an example the apparatus is used to monitor and analyze an electric power system having three phase conductors A, B and C, a neutral conductor N and a ground conductor G. Current transformers sense current flowing in each of these conductors while phase-to-neutral voltages are sensed by the sensing resistors. During harmonic analysis in this example, sampling of all of the currents and voltages at a fast sampling rate is performed first using an A/D converter. The magnitude, either in volts or as a percentage of the fundamental, is then calculated for each harmonic together with the phase angle between the harmonic and a reference waveform. The default reference waveform is the phase A to B line-to-line voltage, unless line to neutral voltages have been selected for display, in which case the referenced waveform is the phase A to neutral voltage. These values are generated for fifty harmonics for each of the five currents IA, IB, IC, IN, IG, or one of three line-to-line voltages, VAB, VBC, VCA, or one of three line-to-neutral voltages, VAN, VBN, VCN. This is accomplished by a Fourier algorithm, which determines a sine and cosine value for each harmonic.

### Summary

### Technical Problem

However, with the frequency detection method disclosed in the Patent Literature 1 described above, a case sometimes occurs where the current waveform of the load current contains many harmonics and thus the waveform has a plurality of zero crossing points in a steady state. In this case, it becomes difficult to set the frequency to fall within the prescribed value of, for example, a deviation of 1 % or more, thereby causing a problem in that it is difficult to correctly express the measured current.

Further, if a load current includes a direct current (DC) offset component and the load current is also small, there can be a case where the current waveform does not include a zero crossing. In this case, it becomes difficult to calculate the period T, thereby causing a problem in that the frequency cannot be correctly detected.

Further, if a current waveform includes a low frequency component, the zero crossing is always changing because of the effect of the low frequency component on the current waveform, thereby causing a problem in that the frequency cannot be correctly detected.

Further, for example, when the configuration is such that the frequency is set not by detection but by a user, then if the current waveform of a load current does not include a zero crossing point, it is difficult to let the user know of the user's own setting error. As a result, the current is measured on the basis of an erroneous frequency setting, which thereby causes a problem in that errors in the measurement accuracy become large and the current cannot be correctly measured.

The present invention has been made in view of the above, and an objective of the present invention is to provide a circuit breaker that can accurately detect the current frequency of an alternating current (AC) flowing along an electric path without needing the zero crossing of the current waveform acquired by a current transformer.

### Solution to Problem

In order to solve the problem and achieve the objective mentioned above, the present invention relates to a circuit breaker capable of opening and closing an electric path along which an AC current flows. The circuit breaker includes: a current transformer configured to output a current signal in accordance with the AC current flowing along the electric path; a reference waveform storage that has stored therein, in advance, reference waveforms of reference frequencies stored, the reference waveforms respectively corresponding to the frequencies, and one of the reference frequencies being equal to the frequency of the AC current; a multiplication unit configured to multiply a current waveform output from the current transformer with each of the reference waveforms stored in the reference waveform storage; a Fourier transformer configured to perform Fourier transformation on each piece of multiplication data obtained by multiplication performed by the multiplication unit, and to thereby convert the multiplication data into frequency components; and a comparison determiner configured to determine whether or not a DC component is included in each piece of the multiplication data converted into frequency components by the Fourier transformer, and to detect a reference frequency, corresponding to multiplication data including the largest DC component, as the frequency of the AC current flowing along the electric path.

### Advantageous Effects of Invention

According to the present invention, the frequency of an AC current flowing along an electric path can be effectively and accurately detected without needing the zero crossing point of the current waveform acquired by a current transformer.

### Brief Description of Drawings

FIG. 1 is a block diagram illustrating a configuration of a circuit breaker according to an embodiment.
FIG. 2 includes views illustrating frequency components included in the result of the multiplication of a measured waveform and a reference waveform.
FIG. 3 includes other views illustrating frequency components included in the result of the multiplication of a measured waveform and a reference waveform.
FIG. 4 includes other views illustrating frequency components included in the result of the multiplication of a measured waveform and a reference waveform.
FIG. 5 includes other views illustrating frequency components included in the result of the multiplication of a measured waveform and a reference waveform.

### Description of Embodiments

An exemplary embodiment of a circuit breaker according to the present invention will be explained below in detail with reference to the accompanying drawings. The present invention is not limited to the following embodiments.

### Embodiment

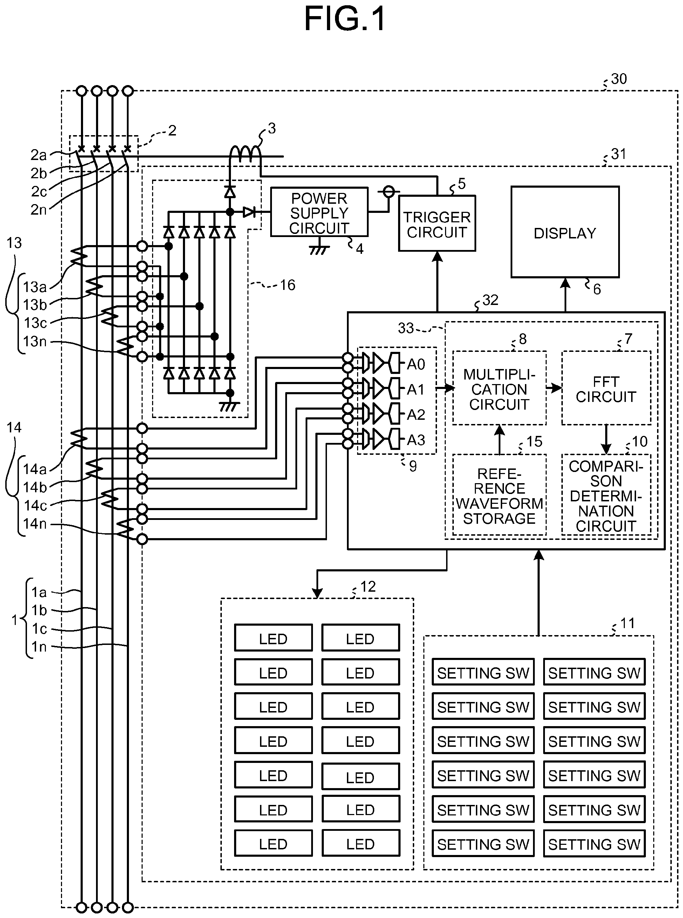

FIG. 1 is a block diagram illustrating a configuration of a circuit breaker according to an embodiment. As illustrated in FIG. 1, the circuit breaker 30 includes electric paths 1 along which AC currents respectively flow; switching contacts 2 respectively provided on the electric paths 1; current transformers 13 configured to output current signals in accordance with currents respectively flowing along the electric paths 1; current transformers 14 configured to output current signals in accordance with currents respectively flowing along the electric paths 1; a cutoff controller 31 configured to generate an operation power source on the basis of current signals sent from the current transformers 13 and to detect currents respectively flowing along the electric paths 1 and the frequencies of the currents on the basis of current signals sent from the current transformers 14 so as to control the switching contacts 2 such that the switching contacts 2 are opened in response to the detection of an over-current; and an electromagnetic device 3 configured to be biased by the cutoff controller 31 so as to open the switching contacts 2 when an over-current flows along the electric paths 1.

The electric paths 1 include electric paths 1a to 1c respectively corresponding to the phases of a three-phase AC. Specifically, the electric path 1a is a first phase AC electric path, the electric path 1b is a second phase AC electric path, and the electric path 1c is a third phase AC electric path. Further, the electric paths 1 include an electric path 1n corresponding to a neutral phase (N phase). Thus, the electric path 1n is a neutral phase AC electric path.

The switching contacts 2 include switching contacts 2a to 2c respectively connected to the electric paths 1a to 1c; and a switching contact 2n connected to the electric path In. All of the switching contacts 2a to 2c and 2n are placed in air, for example. In this case, the circuit breaker 30 is an air circuit breaker.

The current transformers 13 are composed of current transformers 13a to 13c and 13n configured to output current signals in proportion to currents respectively flowing along the electric paths 1a to 1c and In. As described later, the current transformers 13 are connected to a circuit for generating a power source in the circuit breaker 30.

The current transformers 14 are composed of current transformers 14a to 14c and 14n configured to output current signals in proportion to currents respectively flowing along the electric paths 1a to 1c and In. The current transformers 14 are used as current sensors for measuring currents flowing along the electric paths 1.

Further, a configuration that does not include components associated with the neutral phase (such as the electric path 1n and the switching contact 2n) can be made. Further, a configuration can be made that includes only one component associated with one phase of the three phases.

The cutoff controller 31 includes a rectifying circuit 16, a power supply circuit 4, a control processer 32, displays 6 and 12, and a characteristic setting unit 11.

The rectifying circuit 16 is connected to the current transformers 13. The rectifying circuit 16 rectifies current signals output from the current transformers 13, and it outputs them to the power supply circuit 4. The power supply circuit 4 generates an operation power source for the circuit breaker 30. Further, the rectifying circuit 16 is connected to the electromagnetic device 3.

The control processer 32 includes an A/D conversion circuit 9 (A/D converter), a multiplication circuit 8 (multiplication unit), an FFT circuit 7 (Fourier transformer), a comparison determination circuit 10 (comparison determiner), and a reference waveform storage 15. The control processer 32 is configured from the CPU of a microcomputer.

The A/D conversion circuit 9 performs A/D-conversion on current signals output from the current transformers 14, and these converted current signals are read into the control processer 32 as digital data.

The control processer 32 detects currents flowing along the electric paths 1 on the basis of current waveforms acquired by the A/D conversion circuit 9. The control processer 32 calculates the values of currents flowing along the electric paths 1 on the basis of sampled data from the current signals. If the value of a current exceeds a prescribed value, the control processer 32 determines that an over-current flows along the electric paths 1, and it outputs a trip signal to a trigger circuit 5. Upon the input of the trip signal, the trigger circuit 5 biases the electromagnetic device 3. The biased electromagnetic device 3 is excited by a current supplied via the current transformers 13, and it opens the switching contacts 2 by using its electromagnetic force and thereby sets the electric paths 1 to open.

Further, the control processer 32 can display various calculation results, load current states, and so forth, on the display 6 or LED display 12.

Further, the characteristic setting unit 11 reads various setting conditions, which have been set by a user, into the control processer 32. For example, the characteristic setting unit 11 includes a plurality of setting switches (setting SWs) for performing setting. If frequency setting is performed on the user side, a setting switch for setting the frequency setting is included in these setting switches.

The multiplication circuit 8, the FFT circuit 7, the comparison determination circuit 10, and the reference waveform storage 15 constitute a frequency detection part 33.

The multiplication circuit 8 multiplies a current waveform, which has been converted into digital data by the A/D conversion circuit 9, by a reference waveform of a reference frequency stored in the reference waveform storage 15. Here, the reference frequency includes a plurality of frequencies preset as candidates for the frequency of a current flowing along each of the electric paths 1. Further, it is premised that the frequency of a current flowing along each of the electric paths 1 is any one of these reference frequencies. In this embodiment, it is assumed that the reference frequencies are 50 Hz and 60 Hz, for example. The reference waveform is the waveform of a reference frequency (sine wave or cosine wave), and it is set to include a plurality of waveforms where the number of waveforms in the plurality is the same as the number of reference frequencies.

The FFT circuit 7 performs a fast Fourier transformation in order to output data from the multiplication circuit 8 and thereby converts it into frequency component data.

The comparison determination circuit 10, on the basis of output data from the FFT circuit 7, identifies and detects the frequencies of currents respectively flowing along the electric paths 1.

The frequency detection by the frequency detection part 33 is performed individually on each of the phases corresponding to the electric paths 1a to 1c and In.

Next, a description will be given of a method of detecting frequency components of a current waveform (measured waveform) read into the control processer 32. The measured waveform is generally formed from a waveform including a harmonic component, offset component, low frequency component, or any combination of thereof; therefore the frequency of the fundamental wave therein needs to be identified from the measured waveform. Here, it is assumed that the frequency (reference frequency) to be detected is 50 Hz or 60 Hz, for example.

At first, a study of a case will be described where the measured waveform does not include any of a harmonic component, offset component, and low frequency component and where the measured waveform and a reference waveform (dummy waveform) have the same phase.

Let f₁ denote the frequency of the measured waveform, and f₂ denote a reference frequency for comparison (50 Hz or 60 Hz). With the following trigonometric formula, $cos \left(α\right) cos \left(β\right) = \left(cos\left(α+β\right)+cos\left(α-β\right)\right) / 2 ,$ if it is given that α = ω₁t = 2πf₁t and β = ω₂t = 2πf₂t, then multiplication of the measured waveform and the reference waveform gives a waveform expressed as follows: $cos \left({ω}_{1}t\right) cos \left({ω}_{2}t\right) = \left(cos\left({ω}_{1}t+{ω}_{2}t\right)+cos\left({ω}_{1}{t-ω}_{2}t\right)\right) / 2 = \left(cos\left(2π\left({f}_{1}+{f}_{2}\right)t\right)+cos\left(2π\left({f}_{1}-{f}_{2}\right)t\right)\right) / 2$ (1)

Here, in the case of f₁ = f₂, the above formula is rearranged into the following formula, in which a DC component is produced if the frequencies are the same as each other: $cos \left({ω}_{1}t\right) cos \left({ω}_{2}t\right) = 1 / 2 cos \left(2π\left({f}_{1}+{f}_{2}\right)t\right) / 2$

In contrast, in the case of f₁ ≠ f₂, a DC component is not produced. In other words, if the measured waveform and the reference waveform are in phase and have the same frequency, these two waveforms are multiplied to detect the DC component, and thereby the frequency of the measured waveform can be identified. Here, the detection of the DC component can be achieved by performing a Fourier transformation on the waveform obtained by multiplying the measured waveform and the reference waveform and then extracting the DC component therefrom.

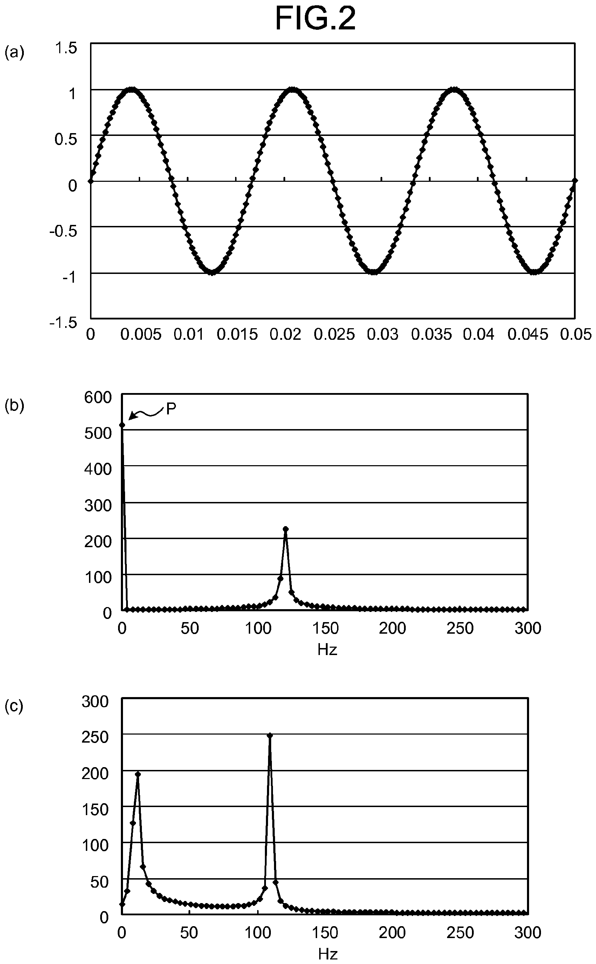

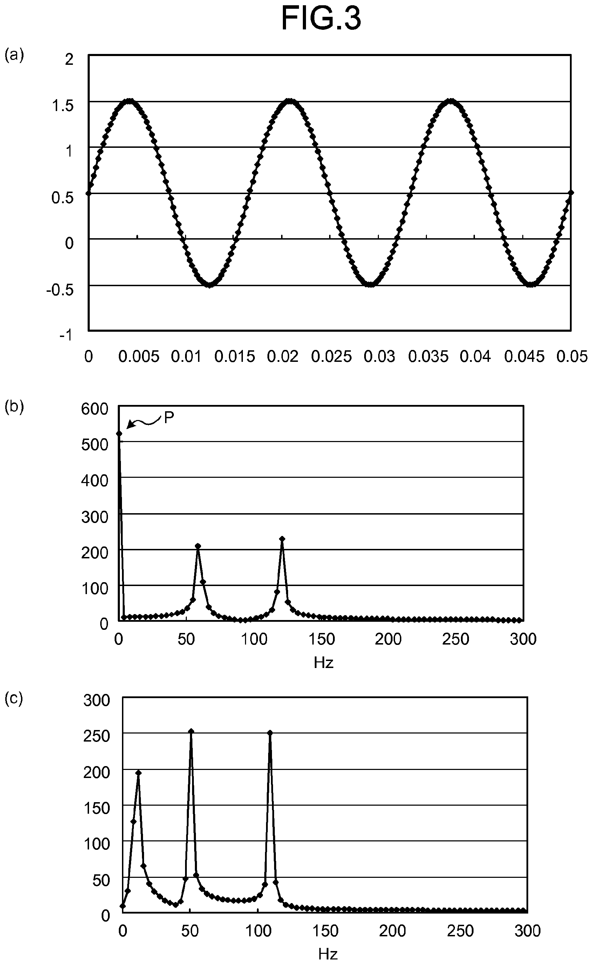

FIG. 2 includes views illustrating frequency components included in the result of the multiplication of a measured waveform and a reference waveform. Specifically, FIG. 2(a) is a view illustrating a measured waveform, which is a sine wave of 60 Hz, and the horizontal axis indicates the time in seconds and the vertical axis indicates a normalized numeric value. FIG. 2(b) is a view illustrating a result of an FFT performed on the product of the multiplication of the measured waveform and a reference waveform, where the reference waveform is a sine wave of 60 Hz in phase with the measured waveform. In this case, a component having a peak P at a frequency of 0, i.e., a DC component, is detected. Consequently, the frequency of the measured waveform can be identified as being 60 Hz, which is the frequency of the reference waveform. FIG. 2(c) is a view illustrating a result of an FFT performed on a product of the multiplication of the measured waveform and a reference waveform, where the reference waveform is a sine wave of 50 Hz that is in phase with the measured waveform. In this case, a component having a peak P at a frequency of 0 is not present, and so a DC component is not detected. However, even if the waveform data is obtained by sampling at constant time intervals, for example, because the number of samplings is limited, a component with a frequency 0 is affected by the skirt of the peak at 10 Hz and therefore does not completely become zero. This is also true in the examples illustrated in FIGS. 3 to 5.

Next, a study of a case will be described where a measured waveform includes an offset component, and where the measured waveform and a reference waveform are in phase. Let A denote the offset component. Then, multiplication of the measured waveform and the reference waveform gives a waveform expressed as follows: $\left(A+cos\left({ω}_{1}t\right)\right) cos \left({ω}_{2}t\right) = Acos \left({ω}_{2}t\right) + cos \left({ω}_{1}t\right) cos \left({ω}_{2}t\right)$ (2)

The first term on the right side of the above formula represents the frequency component of the reference waveform, and the second term on the right side represents the same waveform as the waveform of (1). In this case also, a DC component is produced when f₁ = f₂, and a DC component is not produced when f₁ ≠ f₂. Specifically, even when the measured waveform includes an offset component, if the measured waveform and the reference waveform are in phase and have the same frequency, then these two waveforms are multiplied to detect the DC component, and thereby the frequency of the measured waveform can be identified.

FIG. 3 includes other views illustrating frequency components included in the result of the multiplication of the measured waveform and the reference waveform. Specifically, FIG. 3(a) is a view illustrating a measured waveform, which is a sine wave of 60 Hz including an offset component added thereto, where the horizontal axis indicates a time in seconds and the vertical axis indicates a normalized numeric value. FIG. 3(b) is a view illustrating the result of an FFT performed on a the product of the multiplication of the measured waveform and a reference waveform, where the reference waveform is a sine wave of 60 Hz that is in phase with the measured waveform. In this case, a component having a peak P at a frequency of 0, i.e., a DC component, is detected. Consequently, the frequency of the measured waveform can be identified as being 60 Hz, which is the frequency of the reference waveform. FIG. 3(c) is a view illustrating the result of an FFT performed on the product of the multiplication of the measured waveform and a reference waveform, where the reference waveform is a sine wave of 50 Hz that is in phase with the measured waveform. In this case, a component having a peak P at a frequency of 0 is not present, and therefore a DC component is not detected.

Next, a study of a case will be described where a measured waveform does not include any of a harmonic component, offset component, and low frequency component, and where the measured waveform and a reference waveform (dummy waveform) are not in phase. Let Δ denote the phase difference between the measured waveform and the reference waveform. As in the case where they are in phase, if it is given that α = ω₁t = 2πf₁t and β = ω₂t = 2πf₂t, the waveform is expressed as follows: $\begin{matrix}cos \left({ω}_{1}t+Δ\right) cos \left({ω}_{2}t\right) \\ = \left(cos\left({ω}_{1}t\right)cos\left(Δ\right)-sin\left({ω}_{1}t\right)sin\left(Δ\right)\right) cos \left({ω}_{2}t\right) \\ = cos \left(Δ\right) cos \left({ω}_{1}t\right) cos \left({ω}_{2}t\right) - sin \left(Δ\right) sin \left({ω}_{1}t\right) cos \left({ω}_{2}t\right)\end{matrix}$ (3)

The first term on the right side of the above formula represents the multiplication of the waveform of (1) by cos(Δ). Consequently, in the case of cos(Δ) ≠ 0 and f₁ = f₂, a DC component is produced. Further, in the case of cos(Δ) = 0, i.e., Δ = π/2×n (n = 1, 3, 5, 7 ···), because sin(Δ) = sin(π/2×n) = ±1, then the above formula can be rearranged into the following formula: $\begin{matrix}cos \left({ω}_{1}t+Δ\right) cos \left({ω}_{2}t\right) = \pm sin \left({ω}_{1}t\right) cos \left({ω}_{2}t\right) \\ = \pm \left(sin\left({ω}_{1}t-{ω}_{2}t\right)-sin\left({ω}_{1}t+{ω}_{2}t\right)\right) / 2\end{matrix}$

Here, in the case of f₁ = f₂, the above formula is further rearranged into the following formula: $cos \left({ω}_{1}t+Δ\right) cos \left({ω}_{2}t\right) = \pm sin \left({ω}_{1}t+{ω}_{2}t\right) / 2$

In other words, when the phase difference between the measured waveform and the reference waveform is π/2×n (n = 1, 3, 5, 7 ···), a DC component is not produced even if the frequencies are the same as each other. Further, in the case of f₁ ≠ f₂, a DC component is not produced on the right side of the formula (3).

As described above, in a case where a measured waveform and a reference waveform are not in phase, even if the frequencies are the same as each other, a DC component is not produced on the right side of the formula (3) when the phase difference is π/2×n (n = 1, 3, 5, 7 ···). Consequently, in this embodiment, in order that the frequency of the measured waveform are readily identifiable by detecting the DC component, multiplication of the measured waveform and reference waveform is performed by using a plurality of phase differences by varying the phase of the reference waveform, and thus the fluctuations of the DC component are checked.

Specifically, for each of the reference frequencies, a plurality of reference waveforms with different phases are prepared, such that the phase difference between any two of these reference waveforms does not become an integral multiple of n. According to this preparation, for each of the reference frequencies, a case can definitely be found where the phase difference Δ does not become π/2×n (n = 1, 3, 5, 7 ···) among the products of the multiplication of the measured waveform and the reference waveform. Thus, when the measured waveform and the reference waveform have the same frequency, a DC component having a peak at a frequency of 0 can be detected. In most cases in practice, the measured waveform and the reference waveform are in phase, and so it is necessary to perform a process of checking the fluctuations of the DC component by varying the phase of the reference waveform as described above.

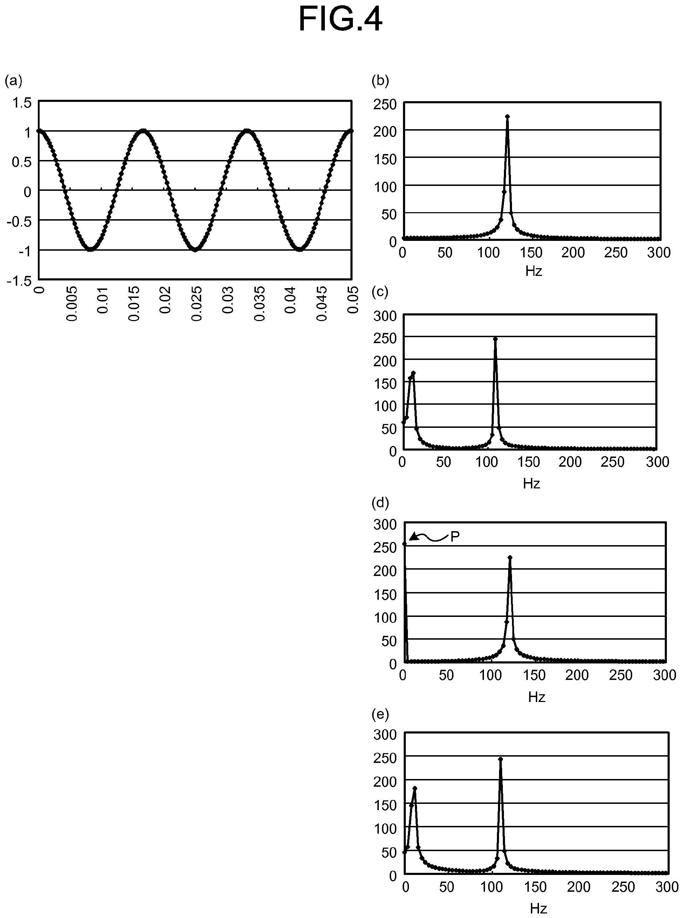

FIG. 4 includes other views illustrating frequency components included in a result of the multiplication of a measured waveform and a reference waveform. Specifically, FIG. 4(a) is a view illustrating a measured waveform, which is a sine wave of 60 Hz. FIG. 4(b) is a view illustrating a result of an FFT performed on a product of the multiplication of the measured waveform and a reference waveform, where the reference waveform is a sine wave with a frequency of 60 Hz and with a phase difference of n/2 relative to the measured waveform. In this case, a component having a peak P at a frequency of 0, i.e., a DC component, is not produced. FIG. 4(c) is a view illustrating a result of an FFT performed on a product of the multiplication of the measured waveform and a reference waveform, where the reference waveform is a sine wave with a frequency of 50 Hz and has a phase difference of n/2 relative to the measured waveform. In this case also, a DC component is not produced. FIG. 4(d) is a view illustrating the result of an FFT performed on a product of the multiplication of the measured waveform and a reference waveform, where the reference waveform is a sine wave with a frequency of 60 Hz and has a phase difference of n/6 relative to the measured waveform. In this case, a component having a peak P at a frequency of 0, i.e., a DC component, is detected. Consequently, the frequency of the measured waveform can be identified as being 60 Hz, which is the frequency of the reference waveform. FIG. 4(e) is a view illustrating the result of an FFT performed on a product of the multiplication of the measured waveform and a reference waveform, where the reference waveform is a sine wave with a frequency of 50 Hz and has a phase difference of n/6 relative to the measured waveform. In this case also, a DC component is not produced.

Next, a study of a case will be described where a measured waveform includes an offset, and where the measured waveform and a reference waveform are not in phase. Let Δ denote the phase difference between the measured waveform and the reference waveform, as described above. Further, let A denote the offset component. Then, multiplication of the measured waveform and the reference waveform provides a waveform expressed as follows: $\begin{matrix}\left(A+cos\left({ω}_{1}t+Δ\right)\right) cos \left({ω}_{2}t\right) \\ = Acos \left({ω}_{2}t\right) + cos \left({ω}_{1}t+Δ\right) cos \left({ω}_{2}t\right)\end{matrix}$ (4)

The first term on the right side of the above formula represents the frequency component of the reference waveform and does not produce a DC component. The second term on the right side represents the same waveform as the waveform of (3). Accordingly, as in the waveform of (3), the frequency of the measured waveform can be identified by detecting the DC component.

Next, a study of a case will be described where a measured waveform includes a low frequency component. If the low frequency component is cos(ω₀t), multiplication of the measured waveform with a reference waveform provides a waveform expressed as follows: $\begin{matrix}\left(cos\left({ω}_{0}t+δ\right)+cos\left({ω}_{1}t+Δ\right)\right) cos \left({ω}_{2}t\right) \\ = cos \left({ω}_{0}t+δ\right) cos \left({ω}_{2}t\right) + cos \left({ω}_{1}t+Δ\right) cos \left({ω}_{2}t\right)\end{matrix}$ (5)

Here, δ denotes the phase difference between the low frequency component and the reference waveform, and Δ denotes the phase difference between the measured waveform and the reference waveform, where δ and Δ respectively include δ = 0 and Δ = 0. Further, it is given that ω₀ < ω₁ and ω₀ < ω₂. The first term on the right side of the above formula does not produce a DC component. The second term on the right side represents the same waveform as the waveform of (3). Consequently, as in the waveform of (3), the frequency of the measured waveform can be identified by detecting the DC component.

Next, a study of a case will be described where a measured waveform is composed of a fundamental wave component and a tertiary harmonic component. The measured waveform is expressed by cos (ω₁t+Δ) +cos (3ω₁t+Δ). Let Δ denote the phase difference between the measured waveform and a reference waveform, where Δ includes Δ = 0. Then, multiplication of the measured waveform and the reference waveform provides a waveform expressed as follows: $\begin{matrix}\left(cos\left({ω}_{1}t+Δ\right)+cos\left(3{ω}_{1}t+Δ\right)\right) cos \left({ω}_{2}t\right) \\ = cos \left({ω}_{1}t+Δ\right) cos \left({ω}_{2}t\right) + cos \left(3{ω}_{1}t+Δ\right) cos \left({ω}_{2}t\right)\end{matrix}$ (6)

The first term on the right side of the above formula represents the same waveform as the waveform of (3). The second term on the right side represents a part derived from a harmonic component, which can be expressed as follows: $\begin{matrix}cos \left(3{ω}_{1}t+Δ\right) cos \left({ω}_{2}t\right) \\ = cos \left(Δ\right) cos \left(3{ω}_{1}t\right) cos \left({ω}_{2}t\right) - sin \left(Δ\right) sin \left(3{ω}_{1}t\right) cos \left({ω}_{2}t\right) \\ = cos \left(Δ\right) \left(cos\left(3{ω}_{1}t+{ω}_{2}t\right)+cos\left(3{ω}_{1}t-{ω}_{2}t\right)\right) / 2 - sin \left(Δ\right) \left(sin\left(3{ω}_{1}t+{ω}_{2}t\right)+sin\left(3{ω}_{1}t-{ω}_{2}t\right)\right) / 2\end{matrix}$

Consequently, in the case of f₁ = f₂, the second term on the right side of the formula (6) does not produce a DC component. Further, in this embodiment, a plurality of reference frequencies have been preset such that none of the reference frequencies is equal to (2n+1) times the frequency of the fundamental wave of the measured waveform (n is a natural number). For example, if the reference frequencies are set to 50 Hz and 60 Hz, this condition is satisfied, which is because the frequency of the measured waveform is supposed to be 50 Hz or 60 Hz. Under this condition, 3f₁ = f₂ (3ω₁ = ω₂) cannot be given, and therefore the second term on the right side of the formula (6) does not produce a DC component in the case of f₁ ≠ f₂.

The mentioned above is also true in a case where a measured waveform includes a quintic or higher harmonic component. In other words, as far as the presence/absence of a DC component is concerned, even when a measured waveform includes a harmonic component, the measured waveform can be considered in the same way as a case where the harmonic component is not included.

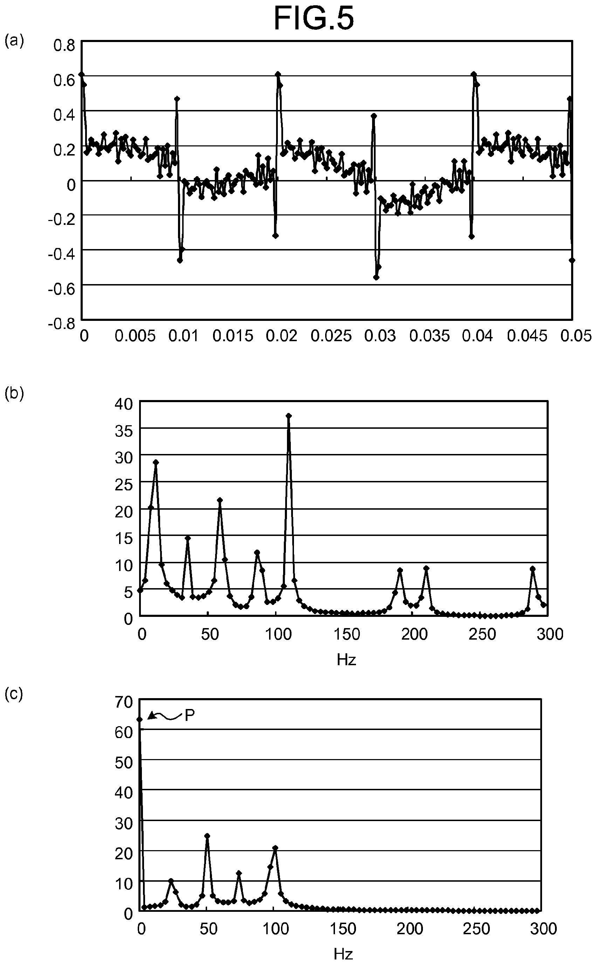

FIG. 5 includes other views illustrating frequency components included in a result of multiplication of a measured waveform and a reference waveform. Specifically, FIG. 5(a) is a view illustrating a measured waveform, which is a sine wave of 50 Hz including a harmonic component, a low frequency component, and an offset component added thereto. FIG. 5(b) is a view illustrating a result of FFT performed on a product of multiplication of the measured waveform and a reference waveform, where the reference waveform is a sine wave of 60 Hz in phase with the measured waveform. In this case, a component having a peak P at a frequency of 0, i.e., a DC component, is not produced. FIG. 5(c) is a view illustrating a result of FFT performed on a product of multiplication of the measured waveform and a reference waveform, where the reference waveform is a sine wave of 50 Hz in phase with the measured waveform.

In this case, a component having a peak P at a frequency of 0, i.e., a DC component, is detected. Consequently, the frequency of the measured waveform can be identified as being 50 Hz which is the frequency of the reference waveform.

As described above, even when a measured waveform includes a harmonic component, offset component, low frequency component, or a combination of them, it is possible to consider whether or not a DC component is included in a product of multiplication of the measured waveform with a reference waveform in the same way as a case where the measured waveform does not include a harmonic component, offset component, low frequency component, or a combination of them. In the above example, including the case of Δ = 0, it can be considered in the same way as the formula (3), and so the frequency can be identified by detecting the DC component.

Consequently, the measured waveform is multiplied by a reference waveform, and the presence/absence of a DC component is confirmed on the basis of the multiplication result. Consequently, the frequency of a current flowing along an electric path 1 can be identified without detecting a zero crossing of the measured waveform.

Next, a description will be given of an operation according to this embodiment. The current transformers 14 output current signals, which correspond to currents respectively flowing along the electric paths 1, to the control processer 32. In the control processer 32, the A/D conversion circuit 9 converts each of the current signals detected by the current transformers 14, from an analog signal into a digital signal.

The multiplication circuit 8 performs multiplication of a current waveform (measured waveform) output from the A/D conversion circuit 9 with each of the reference waveforms stored in the reference waveform storage 15. The reference waveform storage 15 has stored reference waveforms of reference frequencies stored in advance, respectively in association with a plurality of reference frequencies. As described above, one of these reference frequencies is equal to the frequency of an AC current flowing along each of the electric paths 1. Further, the reference waveform storage 15 has stored, in advance, a plurality of reference waveforms for each of the reference frequencies such that they are in different phases and the phase difference between them does not become an integral multiple of n. The multiplication circuit 8 outputs each piece of multiplication data to the FFT circuit 7.

A specific example of the reference waveforms will be described here. It is assumed, for example, that the reference frequencies are f₂₁ = 50 Hz and f₂₂ = 60 Hz. For example, if two reference waveforms are set for each of the reference frequencies, the reference waveforms for the reference frequency of 50 Hz can be cos(ω₂₁t) and cos(ω₂₁t+θ), and the reference waveforms for the reference frequency of 60 Hz can be cos(ω₂₂t) and cos(ω₂₂t+θ). Here, ω₂₁ = 2πf₂₁ and ω₂₂ = 2πf₂₂ are given, and θ is π/6, for example. If the measured waveform is cos(ω₁t+Δ), for example, the multiplication circuit 8 performs an arithmetic operation on the sampled data for cos(ω₁t+Δ)cos(ω₂₁t), cos(ω₁t+Δ)cos(ω₂₁t+θ), cos(ω₁t+Δ)cos(ω₂₂t), and cos(ω₁t+Δ)cos(ω₂₂t+θ).

Then, the FFT circuit 7 performs fast Fourier transformation on the multiplication data output from the multiplication circuit 8 and thereby converts it into frequency component data. The FFT circuit 7 performs an arithmetic operation on each piece of multiplication data obtained by multiplying the measured waveform with one of the reference waveforms. The FFT circuit 7 outputs the calculation result to the comparison determination circuit 10.

The comparison determination circuit 10 performs comparison and determination as to whether or not a DC component is included in the frequency components of each piece of the multiplication data output from the FFT circuit 7 so as to identify multiplication data including a DC component and detect a reference frequency corresponding to the identified multiplication data as the frequency of a current flowing along the corresponding electric path 1. Here, the reference frequency corresponding to the identified multiplication data is the reference frequency of a reference waveform that was used in multiplication for obtaining this multiplication data. In this respect, if a reference frequency is not identical to the frequency of the measured waveform, the DC component in multiplication data is supposed to become ideally zero. However, since waveform data used for the arithmetic operation in the FFT circuit 7 is obtained by sampling a limited sampling time and the number of samplings is limited, a case can occur where the DC component is not zero in practice but is produced at a low value to some extent. Accordingly, the comparison determination circuit 10 compares DC components included in respective pieces of multiplication data to find multiplication data including the largest DC component and detects a reference frequency corresponding to this multiplication data, as the frequency of a current flowing along the corresponding electric path 1.

In the above example, the comparison determination circuit 10 compares the degrees of DC components included in the frequency components of pieces of multiplication data, cos(ω₁t+Δ)cos(ω₂₁t), cos(ω₁t+Δ)cos(ω₂₁t+θ), cos(ω₁t+Δ)cos(ω₂₂t), and cos(ω₁t+Δ)cos(ω₂₂t+θ) so as to identify multiplication data including the largest DC component and detects a reference frequency corresponding to this identified multiplication data, as the frequency of a current flowing along the corresponding electric path 1 (see FIG. 4(d)).

As described above, the circuit breaker 30 according to this embodiment is a circuit breaker capable of opening and closing an electric path 1 along which an AC current flows, and it includes: a current transformer 14 configured to output a current signal in accordance with the AC current flowing along the electric path 1; the reference waveform storage 15 that has in advance stored reference waveforms of reference frequencies, respectively in association with a plurality of reference frequencies, one of which is equal to the frequency of the AC current; the multiplication circuit 8 configured to multiply a current waveform output from the current transformer 14 by each of the reference waveforms stored in the reference waveform storage 15; the FFT circuit 7 configured to perform fast Fourier transformation on each piece of multiplication data obtained by multiplication in the multiplication circuit 8 so as thereby to convert the multiplication data into frequency components; and the comparison determination circuit 10 configured to determine whether or not a DC component is included in each piece of multiplication data converted into frequency components by the FFT circuit 7 so as to detect a reference frequency corresponding to multiplication data including the largest DC component, as the frequency of the AC current flowing along the electric path 1.

According to the configuration described above, even when the current flowing along the electric path 1 includes a harmonic component, offset component, or low frequency component, or any combination of them, no zero crossing point of a current waveform is need to obtain, and therefore, the frequency of the AC current flowing along the electric path 1 can be accurately detected.

Further, according to the embodiment, the characteristic setting unit 11 allows a user to set a frequency. The circuit breaker 30 performs various arithmetic operations and display operations by using the set frequency. In this configuration, even when the user has made an error in setting the frequency, the frequency detection part 33 independently detects frequencies. Consequently, it is possible to detect a setting error made by the user and to inform the user of the probability of the setting error by giving information to the effect via an external display or by a contact output. Specifically, the comparison determination circuit 10 determines whether or not a detected frequency is identical to a frequency set via the characteristic setting unit 11, and if they are not identical, the comparison determination circuit 10 displays information to the effect on the display 6, for example.

### Industrial Applicability

As described above, the circuit breaker according to the present invention is useful as an air circuit breaker.

### Reference Signs List

1, 1a to 1c, 1n electric path, 2, 2a to 2c, 2n switching contact, 3 electromagnetic device, 4 power supply circuit, 5 trigger circuit, 6, 12 display, 7 FFT circuit, 8 multiplication circuit, 9 A/D conversion circuit, 10 comparison determination circuit, 11 characteristic setting unit, 13, 13a to 13c, 13n, 14, 14a to 14c, 14n current transformer, 15 reference waveform storage, 16 rectifying circuit, 30 circuit breaker, 31 cutoff controller, 32 control processer, 33 frequency detection part.

## Claims

1. A circuit breaker (30) capable of opening and closing an electric path (1) along which an AC current flows, the circuit breaker (30) comprising:
a current transformer (14) configured to output a current signal in accordance with the AC current flowing along the electric path (1);
a reference waveform storage (15) that has stored therein, in advance, reference waveforms of reference frequencies,
the reference waveforms respectively corresponding to the frequencies, and
one of the reference frequencies being equal to the frequency of the AC current;
a multiplication unit (8) configured to multiply a current waveform output from the current transformer (14) with each of the reference waveforms stored in the reference waveform storage (15);
a Fourier transformer (7) configured
to perform Fourier transformation on each piece of multiplication data obtained by multiplication performed by the multiplication unit (8), and
to thereby convert the multiplication data into frequency components; and
a comparison determiner (10) configured
to determine whether or not a DC component is included in each piece of the multiplication data converted into frequency components by the Fourier transformer (7), and
to detect a reference frequency, corresponding to multiplication data including the largest DC component, as the frequency of the AC current flowing along the electric path (1).

2. The circuit breaker (30) according to claim 1,
further comprising an A/D converter configured to perform A/D-conversion on the current signal output from the current transformer (14), wherein the multiplication unit (8) is configured to multiply a current waveform, which has been converted into digital data by the A/D converter, with each of the reference waveforms, and
the Fourier transformer (7) is configured to perform fast Fourier transformation on each piece of multiplication data obtained by multiplication performed by the multiplication unit (8).

3. The circuit breaker (30) according to claim 2, wherein
the reference waveform storage (15) has previously stored a plurality of reference waveforms for each of the reference frequencies such that
the plurality of reference waveforms have different phases to each other and
each of the plurality of reference waveforms has a phase difference that is not an integral multiple of n.

4. The circuit breaker (30) according to any one of claims 1 to 3, further comprising a characteristic setting unit (11) configured to set a frequency, wherein
the comparison determiner (10)
determines whether or not a detected frequency is identical to a frequency that is set by the characteristic setting unit (11), and
indicates, if the detected frequency and the set frequency are determined not to be identical, to that effect.

## Patentansprüche

1. Schutzschalter (30), der in der Lage ist, einen elektrischen Pfad (1), entlang dessen ein Wechselstrom fließt, zu öffnen und zu schließen, wobei der Schutzschalter (30) aufweist:
einen Stromwandler (14), der dazu ausgebildet ist, in Übereinstimmung mit dem entlang des elektrischen Pfades (1) fließenden Wechselstroms ein Stromsignal auszugeben;
einen Referenzwellenformspeicher (15), in dem im Voraus Referenzwellenformen für Referenzfrequenzen gespeichert sind,
wobei die Referenzwellenformen jeweils den Frequenzen entsprechen, und wobei eine der Referenzfrequenzen gleich der Frequenz des Wechselstroms ist;
eine Multiplikationseinheit (8), die dazu ausgebildet ist, eine von dem Stromwandler (14) ausgegebene Stromwellenform mit jeder der in dem Referenzwellenformspeicher (15) gespeicherten Referenzwellenformen zu multiplizieren;
einen Fourier-Transformierer (7), der dazu ausgebildet ist,
auf jedem Stück von Multiplikationsdaten, die durch mit der Multiplikationseinheit (8) durchgeführte Multiplikation erhalten wurden,
eine Fourier-Transformation durchzuführen, und
dadurch die Multiplikationsdaten in Frequenzkomponenten umzuwandeln; und
einen Vergleichsbestimmer (10), der dazu ausgebildet ist,
zu bestimmen, ob oder ob nicht in jedem Stück der durch den Fourier-Transformierer (7) in Frequenzkomponenten umgewandelten Multiplikationsdaten eine Gleichstromkomponente enthalten ist, und eine Referenzfrequenz zu erfassen, die den Multiplikationsdaten einschließlich der größten Gleichstromkomponente entspricht, als die Frequenz des entlang des elektrischen Pfades (1) fließenden Wechselstroms zu bestimmen.

2. Schutzschalter (30) nach Anspruch 1
weiter aufweisend einen A/D-Wandler, der dazu ausgebildet ist, eine A/D-Wandlung des von dem Stromwandler (14) ausgegebenen Stromsignals durchzuführen, wobei
die Multiplikationseinheit (8) dazu ausgebildet ist, eine Stromwellenform, die durch den A/D-Wandler in digitale Daten umgewandelt wurde, mit jeder der Referenzwellenformen zu multiplizieren, und
der Fourier-Transformierer (7) dazu ausgebildet ist, auf jedem Stück von Multiplikationsdaten, die durch mit der Multiplikationseinheit (8) durchgeführte Multiplikation erhalten wurde, eine Schnelle-Fourier-Transformation durchzuführen.

3. Schutzschalter (30) nach Anspruch 2, wobei
in dem Referenzwellenformspeicher (15) für jede der Referenzfrequenzen im Voraus eine Mehrzahl von Referenzwellenformen so gespeichert ist, dass
die Mehrzahl der Referenzwellenformen voneinander unterschiedliche Phasen haben und
jede der Mehrzahl von Referenzwellenformen eine Phasendifferenz aufweist, die kein ganzzahliges Vielfaches von π ist.

4. Schutzschalter (30) nach einem der Ansprüche 1 bis 3, weiter aufweisend eine Merkmalseinstelleinheit (11), die zum Einstellen einer Frequenz ausgebildet ist, wobei
der Vergleichsbestimmer (10)
bestimmt, ob oder ob nicht eine ermittelte Frequenz zu einer Frequenz, die durch die Merkmalseinstelleinheit (11) eingestellt ist, identisch ist, und
falls die ermittelte Frequenz und die eingestellte Frequenz als nicht identisch bestimmt werden, dieses angibt.

## Revendications

1. Disjoncteur (30) capable d'ouvrir et de fermer un chemin électrique (1) le long duquel un courant alternatif, CA, circule, le disjoncteur (30) comprenant :
un transformateur de courant (14) configuré pour délivrer en sortie un signal de courant en fonction du courant CA circulant le long du chemin électrique (1) ;
un stockage de formes d'onde de référence (15) qui a stocké en son sein, à l'avance, des formes d'onde de référence de fréquences de référence,
les formes d'onde de référence correspondant respectivement aux fréquences, et
l'une des fréquences de référence étant égale à la fréquence du courant CA;
une unité de multiplication (8) configurée pour multiplier une forme d'onde de courant délivrée en sortie du transformateur de courant (14) avec chacune des formes d'onde de référence stockées dans le stockage de formes d'onde de référence (15) ;
un transformateur de Fourier (7) configuré
pour réaliser une transformée de Fourier sur chaque fragment de données de multiplication obtenues par la multiplication réalisée par l'unité de multiplication (8), et
pour ainsi convertir les données de multiplication en composantes fréquentielles ; et
un déterminant de comparaison (10) configuré
pour déterminer si une composante en courant continu, CC, est incluse ou non dans chaque fragment des données de multiplication converties en composantes fréquentielles par le transformateur de Fourier (7), et pour détecter une fréquence de référence, correspondant à des données de multiplication incluant la plus grande composante en CC, en tant que fréquence du courant CA circulant le long du chemin électrique (1).

2. Disjoncteur (30) selon la revendication 1,
comprenant en outre un convertisseur analogique/numérique, A/N, configuré pour réaliser une conversion A/N sur le signal de courant délivré en sortie du transformateur de courant (14), dans lequel
l'unité de multiplication (8) est configurée pour multiplier une forme d'onde de courant, qui a été convertie en données numériques par le convertisseur A/N, avec chacune des formes d'onde de référence, et le transformateur de Fourier (7) est configuré pour réaliser une transformée de Fourier rapide sur chaque fragment de données de multiplication obtenues par la multiplication réalisée par l'unité de multiplication (8).

3. Disjoncteur (30) selon la revendication 2, dans lequel
le stockage de formes d'onde de référence (15) a précédemment stocké une pluralité de formes d'onde de référence pour chacune des fréquences de référence de sorte que
la pluralité de formes d'onde de référence possèdent des phases différentes les unes des autres et
chacune de la pluralité de formes d'onde de référence possède une différence de phase qui n'est pas un multiple entier de n.

4. Disjoncteur (30) selon l'une des revendications 1 à 3,
comprenant en outre une unité de réglage de caractéristique (11) configurée pour régler une fréquence, dans lequel
le déterminant de comparaison (10)
détermine si une fréquence détectée est identique ou non à une fréquence qui est réglée par l'unité de réglage de caractéristique (11), et
fournit une indication, si la fréquence détectée et la fréquence réglée sont déterminées comme n'étant pas identiques, à ce sujet.
